# EUROPEAN PATENT APPLICATION

(11) **EP 2 207 214 A2**
(43) Date of publication of application: **14.07.2010**
(21) Application number: 10150163.3
(22) Date of filing: 06.01.2010
(51) Int. Cl.: H01L 41/22, H03H 3/02

(54) **Method for manufacturing piezoelectric device**

(30) Priority: 09.01.2009 JP 2009003032
(71) Applicant: Murata Manufacturing Co., Ltd., Nagaokakyo-shi, Kyoto-fu 617-8555 (JP)
(72) Inventor: Iwamoto, Takashi, Nagaokakyo-shi, Kyoto-fu 617-8555 (JP); Kando, Hajime, Nagaokakyo-shi, Kyoto-fu 617-8555 (JP)
(74) Representative: Thévenet, Jean-Bruno

(57) **Abstract**

In a method for manufacturing a piezoelectric device, an ion implantation layer (100) is formed at a desired depth from one principal surface of a piezoelectric single crystal substrate (1) by implanting hydrogen ions into the piezoelectric single crystal substrate under desired conditions. The piezoelectric single crystal substrate in which the ion implantation layer (100) has been formed is bonded to a supporting substrate (30B), and THG laser light is irradiated from the supporting substrate side. Since the optical absorptance of the piezoelectric single crystal substrate (1) to the THG laser light is higher than that of the supporting substrate (30B), the irradiated light is absorbed primarily at the bonding surface side of the piezoelectric single crystal (1) with the supporting substrate (30B) and heat is locally generated. With the generated heat, a piezoelectric thin film (10) is detached from the piezoelectric single crystal substrate (1) using the ion implantation layer (100) as a detaching interface, and a piezoelectric composite substrate including a piezoelectric thin film (10) and the supporting substrate (30B) is formed.

## Description

### BACKGROUND OF THE INVENTION

### 1. Field of the Invention

The present invention relates to a method for manufacturing a piezoelectric single-crystal device including a piezoelectric thin film that is supported by a supporting substrate.

### 2. Description of the Related Art

Various piezoelectric devices including a single-crystal material having piezoelectric characteristics are currently manufactured and used. Among the various piezoelectric devices, a surface acoustic wave (SAW) device, a film bulk acoustic resonator (F-BAR) device, and other devices are examples of piezoelectric devices. Furthermore, to support high-frequency Lamb wave devices, for example, many thin film piezoelectric devices obtained by reducing the thickness of a piezoelectric body have been developed. A method for manufacturing a piezoelectric thin film, such as a thin film piezoelectric device is disclosed, for example, in Y. Osugi et al.: "Single Crystal FBAR With LiNbO3 and LiTaO3", 2007 IEEE MTT-S International Microwave Symposium, pp. 873-876 and in Japanese Unexamined Patent Application Publication No.H11-163363.

"Single Crystal FBAR With LiNbO₃ and LiTaO₃", discloses a deposition method in which a material defining a piezoelectric single crystal, such as AIN or ZnO, is deposited by sputtering or chemical-vapor deposition (CVD) and a polishing method in which a piezoelectric single crystal substrate having a desired thickness is bonded to a supporting substrate and then thinned by polishing.

Japanese Unexamined Patent Application Publication No.H11-163363 discloses a method called a smart cut method. In the smart cut method, for example, a LiNbO₃ substrate or a LiTaO₃ substrate, particularly a piezoelectric substrate composed of such a material is hereinafter referred to as LN substrate or LT substrate, is used as a piezoelectric material and the subsequent processes are performed: (1) an ion implantation layer is formed at a desired depth, at which a piezoelectric thin film is to be formed, from the surface of a piezoelectric substrate by implanting ions into the piezoelectric substrate under suitable conditions; (2) a supporting substrate is bonded to the piezoelectric substrate in which the ion implantation layer has been formed; and (3) a piezoelectric composite substrate is obtained by detaching the piezoelectric thin film, using the ion implantation layer as a detaching interface, by heating the composite member including the piezoelectric substrate and the supporting substrate.

However, when the deposition method described above is used, the material is limited to AIN or other suitable material due to, for instance, the film formation temperature or the film formation conditions that are required to obtain a desired oriented film. Furthermore, since the orientation direction of a crystal axis cannot be controlled, it is difficult to form a crystal to have a desired vibration mode. When the polishing method described above is used, since the portion other than the piezoelectric thin film is treated as polishing waste, the piezoelectric material is not efficiently used. In addition, it is difficult to form a piezoelectric thin film having a uniform thickness because of variations in polishing condition and in the shape of the original piezoelectric substrate, or other factors, which decreases productivity.

When the smart cut method described above is used, heating is performed in the detachment step by using the ion implantation layer. However, since the heating must be performed at a high temperature of at least about 450°C, for a relatively long period of time, such as about 30 minutes, the following problems arise.

Depending on the Curie temperature of the piezoelectric substrate, piezoelectricity thereof is degraded by the high temperature and long heating time and the piezoelectric characteristics of the piezoelectric thin film after detachment are deteriorated.

When LN substrate or LT substrate is used as the piezoelectric substrate, oxygen in the piezoelectric substrate diffuses to the outside due to the high-temperature and the long heating time. Thus, the insulation of the piezoelectric thin film obtained by performing detachment of the piezoelectric substrate near its surface is degraded, and its piezoelectric characteristics are deteriorated.

When an electrode is provided on the surface of the piezoelectric thin film side of the piezoelectric substrate, a metallic element defining the electrode diffuses into the piezoelectric thin film due to the high-temperature and the long heating time. Consequently, the crystal structure of the piezoelectric thin film is likely to be broken and transmission loss in the piezoelectric thin film is increased.

### SUMMARY OF THE INVENTION

Preferred embodiments of the present invention provide a method for manufacturing a piezoelectric device using a piezoelectric single crystal that overcomes the problems that arise by performing high-temperature heating for a relatively long time.

According to a preferred embodiment of the present invention, a method for manufacturing the piezoelectric device includes a step of forming an ion implantation layer by implanting ions into a piezoelectric substrate, a step of disposing a supporting substrate on the ion implanted surface of the piezoelectric substrate and a step forming a piezoelectric composite substrate including a piezoelectric thin film and the supporting substrate by detaching the piezoelectric thin film from the piezoelectric substrate in which the ion implantation layer has been formed, by heating the piezoelectric substrate. To form the piezoelectric composite substrate, a method of light irradiation applied to the portion at which the piezoelectric thin film is formed in the piezoelectric substrate is used.

With this manufacturing method, instead of performing normal atmospheric heating, light is irradiated to the piezoelectric composite member and localized heating is performed on the piezoelectric thin film by the heat that is generated by absorbing the light at the piezoelectric thin film portion. Thereby, a necessary amount of heat for detaching can be applied in a relatively short time.

Additionally, in the method of manufacturing a piezoelectric device according to a preferred embodiment of the present invention, a light having a wavelength such that an optical absorptance of the piezoelectric substrate is higher than that of the supporting substrate when the piezoelectric substrate and the supporting substrate have the same or substantially the same thickness is irradiated from the supporting substrate side in the step of forming the piezoelectric composite substrate.

Additionally, a manufacturing method of a piezoelectric device according to another preferred embodiment of the present invention, a light having a wavelength such that an optical absorptance of the piezoelectric substrate is lower than that of the supporting substrate when the piezoelectric substrate and the supporting substrate have the same or substantially the same thickness is irradiated from the piezoelectric substrate side in the step of forming the piezoelectric composite substrate.

To irradiate light to the piezoelectric composite substrate in these manufacturing methods, the light irradiation direction is determined by a relationship with the irradiated light between the optical absorptance of the piezoelectric substrate and that of the supporting substrate. Specifically, when irradiating a light having a wavelength such that the piezoelectric substrate has a higher optical absorptance, the light is irradiated from the supporting substrate side. Alternatively, when irradiating a light having a wavelength such that the supporting substrate has a higher optical absorptance, the light is irradiated from the piezoelectric substrate side. Thereby, the light is absorbed and the heat is generated effectively at the piezoelectric thin film region which is disposed near the bonding interface of the piezoelectric substrate and the supporting substrate. Thereby, the detaching can be performed using a minimum amount of the light irradiation necessary depending on the combination of the piezoelectric substrate and the supporting substrate.

Additionally, in the step of forming the piezoelectric composite substrate with the manufacturing method of a piezoelectric device according to various preferred embodiments of the present invention, the light having wavelength such the the ratio of the optical absorptance with the same thickness as the piezoelectric substrate to that of the supporting substrate is equal to or greater than about 2 times is irradiated.

When the ratio of the optical absorptance of the piezoelectric substrate to that of the supporting substrate is equal to or greater than about 2 times, an unnecessary temperature increase is avoided and a deterioration of the characteristics is more effectively prevented.

Additionally, a manufacturing method of a piezoelectric device according to a preferred embodiment of the present invention includes a step of disposing a light absorbing layer in the bonding interface of the piezoelectric substrate and the supporting substrate, which has a higher optical absorptance than those of the piezoelectric substrate and the supporting substrate at a particular wavelength. In this manufacturing method, a light having the particular wavelength is irradiated in the step of forming the piezoelectric composite substrate.

In this manufacturing method, the light absorbing layer is disposed at the bonding interface of the piezoelectric substrate and the supporting substrate, and a light is irradiated which is easily absorbed at the light absorbing layer. Thereby, the light absorbing layer generates heat and the bonding interface of the piezoelectric substrate and the supporting substrate, that is piezoelectric thin film region, is effectively heated up.

Additionally, in this manufacturing method of the piezoelectric device according to various preferred embodiments of the present invention, a light having a wavelength such that the ratio of the optical absorptance of the light absorbing layer to either one of lower optical absorptance between the piezoelectric substrate and the supporting substrate is equal to or greater than about 2 times, is irradiated from the side of the piezoelectric substrate or the supporting substrate having a lower optical absorptance.

With this manufacturing method, by setting the ratio of the optical absorptance of the light absorbing layer to either one of the optical absorptance that is lower between the piezoelectric substrate and the supporting substrate so as to be equal to or greater than about 2 times, a similar effect of having the ratio of the optical absorptance of the piezoelectric substrate to that of the supporting substrate equal to or greater than about 2 times is obtained. Thereby, during the heat generation at the light absorbing layer, an unnecessary temperature increase is prevented.

Additionally, a manufacturing method of a piezoelectric device according to various preferred embodiments of the present invention includes a step of forming a metallic electrode pattern in the bonding interface of the piezoelectric substrate and the supporting substrate.

With this manufacturing method, even if the metallic electrode pattern is provided at the bonding interface, since only local heating or a short time is required to be performed, metal diffusion is avoided and deterioration of the characteristics is prevented.

According to various preferred embodiments of the present invention, when manufacturing a piezoelectric device with the smart cut method using a piezoelectric single crystal material, deteriorations of various characteristics caused by long term heating are prevented and a piezoelectric device having excellent characteristics can be manufactured.

Other elements, features, steps, characteristics and advantages of the present invention will become more apparent from the following detailed description of the preferred embodiments with reference to the attached drawings.

### BRIEF DESCRIPTION OF THE DRAWINGS

Fig. 1 shows a flow chart of a method for manufacturing a thin film piezoelectric device according to a preferred embodiment of the present invention.

Figs. 2A to 2E schematically show a manufacturing process of the thin film piezoelectric device formed according to the manufacturing flow shown in Fig. 1.

Figs. 3A to 3D schematically show a manufacturing process of the thin film piezoelectric device formed according to the manufacturing flow shown in Fig. 1.

Figs. 4A and 4B schematically show a manufacturing process of the thin film piezoelectric device formed according to the manufacturing flow shown in Fig. 1.

Fig. 5 is a graph showing the relationship between the ratio of the optical absorptance of the piezoelectric substrate 1 to that of the supporting substrate and the temperature of the bonding interface of the piezoelectric substrate and the supporting substrate when detachment is performed.

Fig. 6 is a flow chart showing a manufacturing flow of the process of disposing a light absorbing layer.

### DETAILED DESCRIPTION OF PREFERRED EMBODIMENTS

A manufacturing method of a piezoelectric device according to preferred embodiments of the present invention will be disclosed with reference to the accompanying drawings. As an example, thin film piezoelectric devices for F-BAR using a piezoelectric single crystal material will be disclosed below.

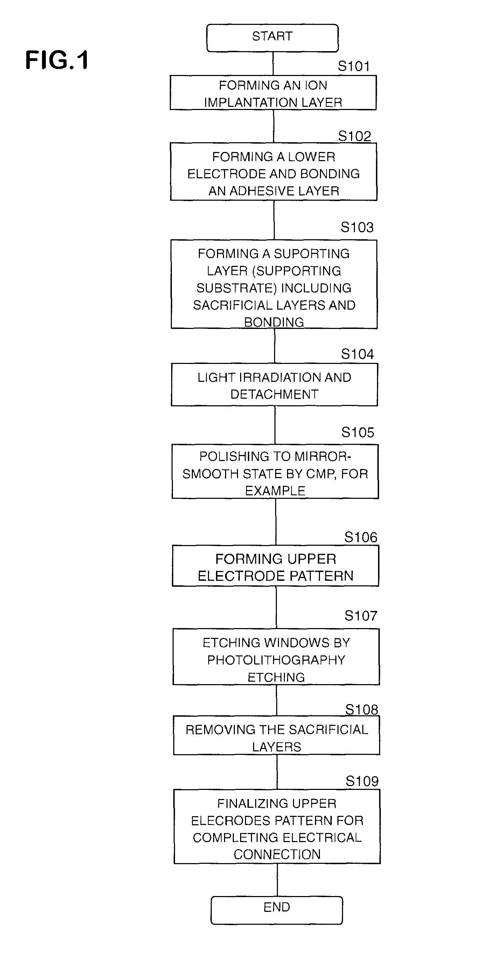

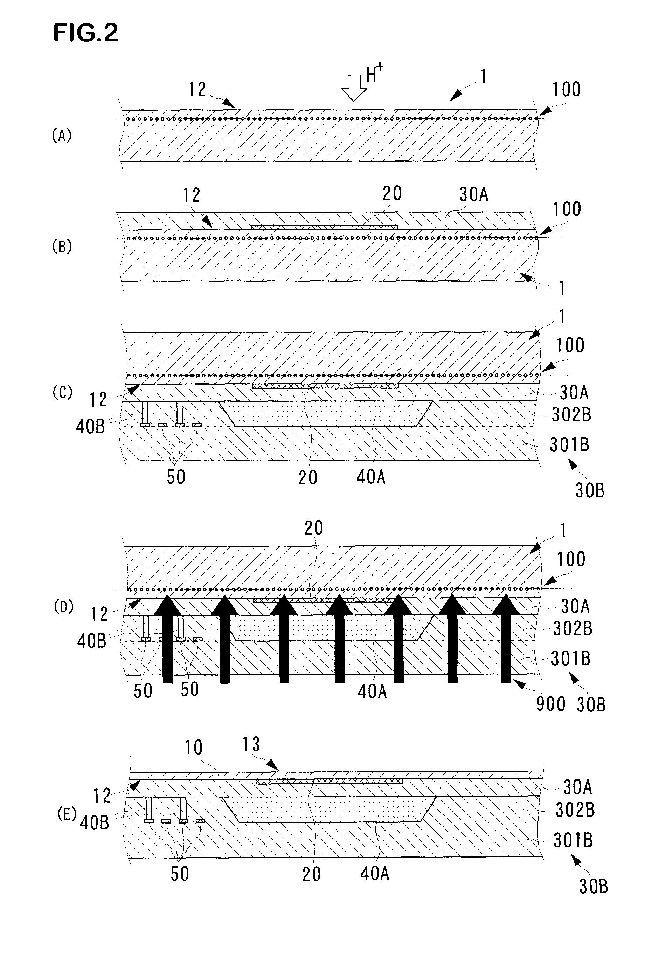

Fig. 1 shows a flow chart of a method for manufacturing a thin film piezoelectric device according to a preferred embodiment of the present invention. Figs. 2A to 4B schematically show a manufacturing process of the thin film piezoelectric device formed according to the manufacturing flow shown in Fig. 1.

A piezoelectric single crystal substrate 1 having a specified thickness is prepared, and an ion implantation layer 100 is formed by implanting hydrogen ions from the back side surface 12 of the substrate, as sown in Fig. 2A. (Fig.1: S101) The piezoelectric substrate 1 having a number of thin film piezoelectric devices formed thereon is used. For example, when a LT substrate is used as the piezoelectric single crystal substrate 1, a hydrogen ion layer is preferably formed at a depth of about 1 µm, for example, from the back surface 12 by implanting hydrogen ions preferably with an acceleration energy of about 150 keV and at a dose amount of about 1.0 x 10¹⁷ atom/cm², for example. Consequently, the ion implantation layer 100 is formed. Instead of a LT substrate, a LN substrate, a Li₂B₄O₇ (LBO) substrate, or a La₃Ga₅SiO₁₄ (langasite) substrate, for example, may preferably be used as the piezoelectric single crystal substrate 1, and ion implantation is performed under conditions that are suitable to each of the substrates.

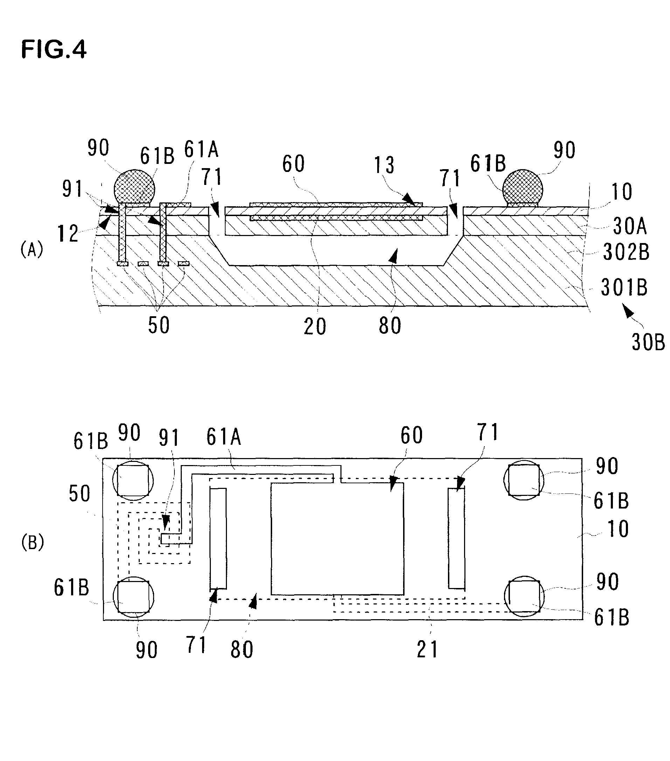

As shown in Fig. 2B, a lower electrode 20 and a lower wiring electrode 21 (refer to Fig.4B), having a desired thickness, are formed on the back surface 12 of the piezoelectric single crystal substrate 1 preferably using aluminum (Al) or other suitable material, for example. Furthermore, an adhesive layer 30A is formed on the back surface 12 on which the lower electrode 20 and the lower wiring electrode 21 have been formed (Fig. 1: S102). For example, a SiO₂ film is preferably used as the adhesive layer 30A, and its surface is preferably planarized by polishing, such as chemical mechanical polishing (CMP), for example.

A supporting substrate 30B is prepared separately. The supporting substrate 30B is defined by forming a supporting layer 302B on a mother substrate 301B. For the mother substrate 301B, an insulating material, such as borosilicate glass, for example, which is a mixture of SiO₂ and B₂O₃ and has a predetermined optical absorptance with a light having a particular wavelength is preferably used, for example. Hereafter, a preferred embodiment in which borosilicate glass is used will be disclosed. A circuit electrode pattern 50 and the supporting layer 302B preferably composed of SiO₂, for example, are formed on the mother substrate 301B. In addition, by, for example, etching the supporting layer 302B, a depression is formed in the area corresponding to a region at which an upper electrode described below are to be formed while a through hole is formed in the area corresponding to a portion of the circuit electrode pattern 50. A material for a sacrificial layer is deposited in the depression and the through hole to form sacrificial layers 40A and 40B, and the surface of the supporting layer 302B is preferably planarized by CMP, for example.

As shown in Fig. 2C, the piezoelectric single crystal substrate 1 is attached to the supporting substrate 30B by directly bonding the supporting layer 302B of the supporting substrate 30B to the surface of the adhesive layer 30A using a surface activated bonding technology (Fig. 1: S103). The surface activated bonding is a method in which bonding is performed while a joining surface is activated by applying Ar ions or other suitable ions, for example, under a vacuum pressure. This bonding method does not require the application of heat. Even if coefficients of linear expansion between the piezoelectric single crystal substrate 1 and the adhesive layer 30A and between the adhesive layer 30A and the supporting substrate 30B are different, breakages can be prevented from occurring at each interface because the joining surface is not heated during the surface activated bonding. Furthermore, since heat is not applied to the piezoelectric single crystal substrate 1, the degradation of characteristics caused by heating is prevented. Moreover, since an OH group is not used, unlike in hydrophilic bonding, voids caused by the generation of hydrogen are also prevented.

As shown in Fig. 2D, to the piezoelectric single crystal substrate 1 to which the supporting substrate 30B is bonded, THG laser light 900 having wavelength 355nm is irradiated from the supporting substrate 30B side to perform detachment. (Fig. 1: S104). The irradiation time is preferably set to about 100 µsec, for example.

Optical absorptance (which is defined as 1 - (transmittance + reflectance)) with the light having a wavelength of 355nm is about 7% to about 8% for the borosilicate glass used for the supporting substrate 30B with a thickness of about 300 µm and about 35% to about 40% for a reduction treated LT substrate of the piezoelectric single crystal substrate 1 with a thickness of about 10 µm. Therefore, even if the light is irradiated from the supporting substrate 30B side, it is not significantly absorbed at the supporting substrate 30B but is primarily absorbed at the bonding surface side of the piezoelectric single crystal substrate 1. Accordingly, the temperature near the bonding interface between the piezoelectric single crystal substrate 1 and the supporting substrate 30B is locally increased. Thereby, the ion implanted layer 100 formed near the bonding interface of the piezoelectric single crystal substrate 1 is increased to a temperature that is sufficient for heated detachment and detachment is performed. By performing heated detachment in that manner, as shown in Fig. 2E, a piezoelectric composite substrate including a piezoelectric thin film 10 which is supported by the supporting substrate 30B is formed. Since the irradiation time of the laser light is very short, for example about 100 µsec, as described above, the temperature for detachment must be maintained for only a short amount of time. Thereby, since extended high temperature heating is not performed, degradations of piezoelectricity and insulation properties are effectively prevented. Furthermore, diffusion from the lower electrode 20 or the circuit electrode pattern 50 into the piezoelectric thin film 10 is prevented.

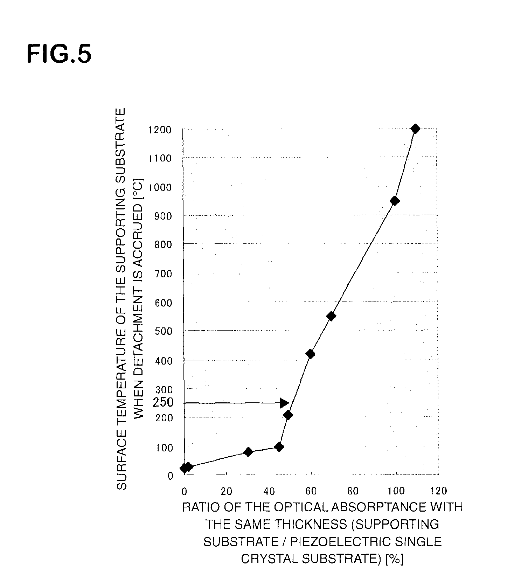

In addition, by irradiating the light having a specific relationship with the ratio of the optical absorptance of the piezoelectric substrate 1 to that of the supporting substrate 30B, the amount of temperature increase can be further minimized. Table 1 shows a relationship between the ratio of the optical absorptance of the piezoelectric substrate 1 to that of the supporting substrate 30B and the temperature of the bonding interface when detachment is performed. Fig. 5 is a graph illustrating the relationship shown in the Table 1.

**Table 1**

| | | | | | | | | | |
|---|---|---|---|---|---|---|---|---|---|
| Ratio of the optical absorptance with the same thickness (Supporting substrate/ Piezoelectric single crystal substrate) (%) | 0.1 | 2.0 | 30 | 45 | 49 | 60 | 70 | 100 | 110 |
| Temperature of the bonding interface when detachment is accrued (°C) | 25 | 30 | 80 | 100 | 210 | 420 | 550 | 950 | 1200 |

As shown in Table 1 and Fig. 5, when the optical absorptance of the supporting substrate 30B is approximately equal to or less than about 1/2 of the optical absorptance of the piezoelectric single crystal substrate 1, the temperature at the bonding interface when detachment is performed can be set to less than about 250°C. In other words, when the optical absorptance of the piezoelectric substrate 1, which has a higher optical absorptance than that of the supporting substrate 30B, is equal to or greater than about 2 times of the optical absorptance of the supporting substrate 30B, the temperature at the bonding interface when detachment is performed can be set to less than about 250°C, for example. Thereby, the degradation of piezoelectricity, the degradation of insulation properties, and the metal diffusion are more effectively prevented. As a result, a piezoelectric composite substrate including the piezoelectric thin film 10 which has excellent characteristics is formed.

In addition, since stress caused by heating is reduced by reducing the heating temperature, even if the thermal expansion coefficients are different, cracking caused by the stress is prevented. Thereby, a material having excellent temperature characteristics and/or excellent power handling capabilities, but which has a different thermal expansion coefficient from the that of the piezoelectric substrate 1, can be effectively used for the supporting substrate. Therefore, range of materials which can be used for the supporting substrate can be increased and a low cost material can be chosen as well.

Furthermore, since a conventional heating process in which the atmospheric temperature is increased is usually required to be performed by increasing and decreasing the temperature gradually with a specific profile, throughput of the detachment process has been relatively low. However, according to a preferred embodiment of the present invention, since the detachment is performed with a short heating time and a very short duration of laser light irradiation, throughput of the detachment process is dramatically improved.

A detached interface (surface) 13 of the piezoelectric thin film 10 is preferably polished to a mirror-smooth state by CMP or other suitable method (Fig. 1: S105). The mirror finish of the surface 13 improves the characteristics of a piezoelectric device.

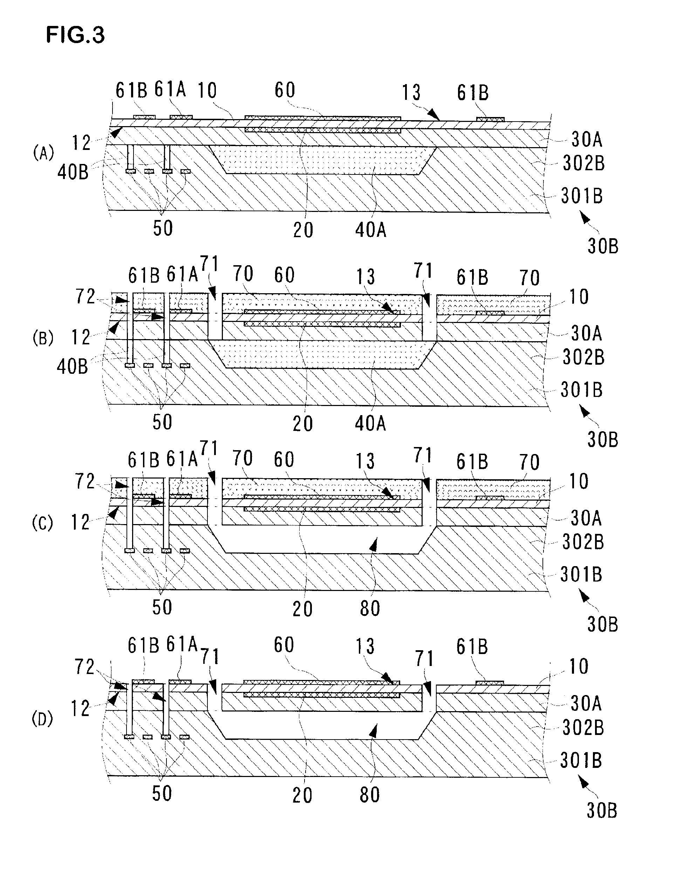

As shown in Fig. 3A, a upper electrode pattern including an upper electrode 60, a wiring electrode 61A and the bump pad 61B, is formed on the surface 13 of the piezoelectric thin film 10 (Fig. 1: S106). A resist film 70 is formed on the surface of the piezoelectric thin film 10 on which the upper electrode pattern has been formed and, as shown in Fig. 3B, etching windows 71 and 72 to remove the sacrificial layers 40A and 40B are formed in the resist film 70 preferably by photolithography, for example (Fig. 1: S107).

As shown in Fig. 3C, the sacrificial layers 40A and 40B are removed by introducing an etching solution or an etching gas into the etching window 71. As a result, the space in which the sacrificial layer 40A is formed and that corresponds to the region at which the lower electrode 20 and upper electrode 60 of the single thin film piezoelectric device are formed is changed to a depletion layer 80 (Fig. 1: S108). After the removal of the sacrificial layers 40A and 40B, the resist film 70 is removed as shown in Fig. 3D.

As shown in Fig. 4A, through hole electrodes 91 that connect the circuit electrode pattern 50 to the wiring electrode 61A and the bump pad 61B are formed as an upper electrode to complete a thin film piezoelectric device while a bump 90 is formed on the bump pad 61B (Fig. 1: S109). As shown in Fig. 4B, the mother substrate is then cut into individual thin film piezoelectric devices. Thus, a thin film piezoelectric device is formed.

In the manufacturing method according to this preferred embodiment, that is, a method including a step of performing heated detachment using light irradiation, the problems that arise when the known smart-cut method utilizing high temperature heating for a long period of time is used are overcome and a thin film piezoelectric device having outstanding characteristics and properties can be manufactured.

Although an example of the laser light irradiation which is absorbed more easily at the piezoelectric single crystal substrate than at the supporting substrate from the supporting substrate side is described above, laser light which is absorbed more easily at the supporting substrate than at the piezoelectric single crystal substrate can preferably be irradiated from the piezoelectric single crystal substrate 1 side as well.

For example, after forming the supporting substrate with a Si substrate and making the surface of the substrate rough using plasma to form microscopic concavities and convexities, a SiN film is formed thereon and polished to a mirror-smooth finish by CMP. After completing such treatment, laser light preferably having a wavelength of about 1.064 µm, for example, is irradiated from the piezoelectric single crystal substrate side. At this wavelength, optical absorptance of the piezoelectric single crystal substrate 1 made of a LT substrate is about 20% with a thickness of about 300 µm, for example, and optical absorptance of the supporting substrate made of Si substrate is about 40% to about 50% with a thickness of about 100 µm, for example. Accordingly, the surface of the supporting substrate, that is the bonding interface, is locally heated by the irradiation of the laser light from the piezoelectric single crystal substrate side, and detachment is performed. Therefore, substantially the same effects as in the manufacturing method described above are obtained with this method.

In addition, a light absorbing layer may be disposed at the bonding interface between the piezoelectric single crystal substrate and the supporting substrate.

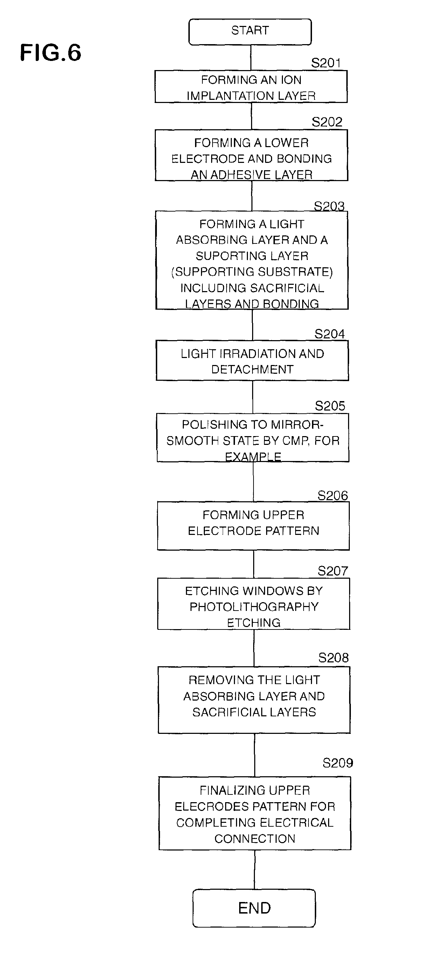

Fig. 6 shows a manufacturing flow chart of a process of forming a light absorbing layer. The manufacturing method of a piezoelectric device including the light absorbing layer as shown in Fig, 6 differs from the manufacturing method shown in Fig. 1 in the process of forming a supporting layer including the light absorbing layer, but is the same or substantially the same in the other processes, and therefore, description of the other processes is omitted.

A manufacturing method of a supporting substrate including a light absorbing layer, for example, includes a step of plating Ni-Zn alloy (black nickel) on a surface of a supporting substrate made of glass. Then, the surface of the plated layer is roughened by sand blasting or other suitable method, for example, and the light absorbing layer is formed. After forming a sacrificial layer on the supporting substrate in which the light absorbing layer is formed, the supporting substrate is bonded to a piezoelectric single crystal substrate (Fig. 6: S203). A laser light having a wavelength of about 10 µm, for example, is irradiated. The laser light is preferably irradiated in the direction from piezoelectric single crystal substrate side. To the laser light having a wavelength of about 10 µm, the optical absorptance of the piezoelectric single crystal substrate including a LT substrate and the supporting substrate made of glass are about 3% to about 5% with a thickness of about 300 µm, and the optical absorptance of the light absorbing layer formed by Ni-Zn alloy is about 80% to about 90% with a thickness of 1 µm. Accordingly, laser light is absorbed near the surface of the light absorbing layer which is locally heated thereby, and detachment is performed. Therefore, substantially the same effects as the manufacturing method described above are obtained with this method.

By considering a ratio of the optical absorptance of the piezoelectric single crystal substrate to that of the supporting substrate or by forming a light absorbing layer, other laser light can be used. For example, CO₂ laser light having a wavelength of about 10600 nm, YAG laser light having a wavelength of about 1064 nm, SHG laser light having a wavelength of about 532 nm, FHG laser light having a wavelength of about 266 nm, ArF laser light having a wavelength of about 193 nm, KrF laser light having a wavelength of about 248 nm, XeF laser light having a wavelength of about 353 nm, or XeCl laser light having a wavelength of about 308 nm may preferably be used. Furthermore, a light which as a broad wavelength including a plurality of these different wavelengths may preferably be used. Namely, by setting the wavelength of the laser light, the material of the piezoelectric single crystal substrate, the material of the supporting substrate, and the direction of irradiating light appropriately, effective detachment by light irradiation can be performed. Thereby, a piezoelectric device having degraded characteristics is prevented from being manufactured.

In the description provided above, a method for manufacturing an F-BAR device has been described. However, the manufacturing method according to various preferred embodiments of the present invention can also be applied to a SAW device, a Lamb wave device, a gyro, a radio frequency (RF) switch, and other suitable devices, for example, that use a different piezoelectric thin film. The manufacturing method according to various preferred embodiments can further be applied to a pyroelectric device and other crystalline devices.

In the description provided above, a thin film piezoelectric device including a lower electrode has been described. However, the manufacturing method according to various preferred embodiments can be applied to a thin film piezoelectric device which does not include a lower electrode.

While preferred embodiments of the present invention have been described above, it is to be understood that variations and modifications will be apparent to those skilled in the art without departing the scope of the present invention. The scope of the present invention, therefore, is to be determined solely by the following claims.

## Claims

1. A method for manufacturing a piezoelectric device, comprising:
a step of forming an ion implantation layer (100) by implanting ions into a piezoelectric substrate (1); and
a step of disposing a supporting substrate (30B) on the ion implanted surface of the piezoelectric substrate (1); and
a step of forming a piezoelectric composite substrate including a piezoelectric thin film (10) and the supporting substrate (30B) by detaching the piezoelectric thin film (10) from the piezoelectric substrate (1) in which the ion implantation layer (100) has been formed, by heating the piezoelectric substrate (1); wherein
in the step of forming the piezoelectric composite substrate, a light is irradiated to a portion of the piezoelectric composite substrate at which the piezoelectric thin film (10) is formed in the piezoelectric substrate.

2. The method for manufacturing a piezoelectric device according to Claim 1, wherein
a light having a wavelength such that an optical absorptance of the piezoelectric substrate (1) is higher than that of the supporting substrate (30B) when the piezoelectric substrate (1) and the supporting substrate (30B) have the same or substantially the same thickness is irradiated from the supporting substrate side in the step of forming the piezoelectric composite substrate.

3. The method for manufacturing an piezoelectric device according to Claim 1, wherein
a light having a wavelength such that an optical absorptance of the piezoelectric substrate (1) is lower than that of the supporting substrate (30B) when the piezoelectric substrate (1) and the supporting substrate (30B) have the same or substantially the same thickness is irradiated from the piezoelectric substrate side in the step of forming the piezoelectric composite substrate.

4. The method for manufacturing an piezoelectric device according to Claim 1, wherein
a light having wavelength such that a ratio of the optical absorptance with substantially the same thickness of the piezoelectric substrate (1) to that of the supporting substrate (30B) is equal to or greater than about 2 times is irradiated.

5. The method for manufacturing a piezoelectric device according to Claim 1, further comprising:
a step of disposing a light absorbing layer, which has higher optical absorptance than those of the piezoelectric substrate (1) and the supporting substrate (30B) to a light having a particular wavelength, in a bonding interface of the piezoelectric substrate (1) and the supporting substrate (30B); wherein
in the step of forming the piezoelectric composite substrate, a light having the particular wavelength light is irradiated.

6. The method for manufacturing a piezoelectric device according to Claim 5, wherein
a light having a wavelength such that a ratio of the optical absorptance of the light absorbing layer to either one of a lower optical absorptance between the piezoelectric substrate (1) and the supporting substrate (30B) is equal to or greater than about 2 times is irradiated from the side of the piezoelectric substrate (1) or the supporting substrate (30B) which has lower optical absorptance.

7. The method for manufacturing a piezoelectric device according to Claim 1, further comprising a step of forming a metallic electrode pattern (20) in the bonding interface of the piezoelectric substrate (1) and the supporting substrate (30B).
